# EUROPEAN PATENT APPLICATION

(11) **EP 4 730 369 A1**
(43) Date of publication of application: **22.04.2026**
(21) Application number: 24916257.9
(22) Date of filing: 10.05.2024
(51) Int. Cl.: H01F 10/14, H10F 77/00, H10F 77/20, H10F 71/00, H10F 77/30

(54) **P-TYPE TBC SOLAR CELL AND MANUFACTURING METHOD THEREFOR**

(30) Priority: 11.01.2024 CN 202410050057
(71) Applicant: CHINT New Energy Technology Co., Ltd., Haining, Zhejiang 314400 (CN)
(72) Inventor: MA, Yuchao, Jiaxing, Zhejiang 314400 (CN); CAI, Yongmei, Jiaxing, Zhejiang 314400 (CN); HE, Sheng, Jiaxing, Zhejiang 314400 (CN); HSU, Wei-chih, Jiaxing, Zhejiang 314400 (CN)
(74) Representative: PGA S.p.A., Milano, Succursale di Lugano
(86) International application number: PCT/CN2024/092201
(87) International publication number: WO 2025/148200

(57) **Abstract**

A P-type TBC solar cell and a manufacturing method therefor. The P-type TBC solar cell comprises P-type substrate silicon, wherein the backside of the P-type substrate silicon comprises a patterned N-type region; in the N-type region, a first tunneling layer, an N-type polysilicon layer, a first conductive shielding layer, a first passivation anti-reflection layer and a non-silver N fine finger are sequentially disposed outwards from the backside of the P-type substrate silicon; and the non-silver N fine finger penetrates the first passivation anti-reflection layer to come into contact with the first conductive shielding layer. In the present invention, a non-silver N fine finger is used as a metal electrode in an N-type region of the back face of a cell, such that the production costs of a P-type TBC solar cell can be greatly reduced; moreover, by means of providing a conductive shielding layer between the non-silver N fine finger and a corresponding polysilicon, metal slurry is prevented from coming into direct contact with the polysilicon during sintering of the non-silver N fine finger, such that the contact resistance is greatly reduced, fill factors of the cell are increased, an open-circuit voltage of the cell is increased and the photoelectric conversion efficiency of the cell is improved.

## Description

This application claims priority to Chinese Patent Application No. 202410050057.6, titled "P-TYPE TBC SOLAR CELL AND MANUFACTURING METHOD THEREFOR", filed on January 11, 2024 with the China National Intellectual Property Administration, which is incorporated herein by reference in its entirety.

### FIELD

The present disclosure relates to the field of photovoltaic power generation and in particular to a P-type TBC solar cell and manufacturing method thereof.

### BACKGROUND

With the continuous development of solar cell technology, the research, development and manufacture of high-efficiency, stable, and low-cost solar cells have become a focus of the industry. Compared to P-type crystalline silicon solar cells, N-type crystalline silicon solar cells, exhibiting a longer minority carrier lifetime, no light-induced degradation, better low-light performance, and a lower temperature coefficient, are regarded as a promising candidate for crystalline silicon solar cells to approach their theoretical maximum efficiency.

The tunneling oxide passivated back contact (TBC) solar cell are a back-junction, back-contact solar cell structure in which positive and negative metal electrodes are arranged in an interdigitated pattern on the rear surface of the solar cell. The p-n junction is located on the rear surface of the solar cell, using P+ doped polycrystalline silicon as an emitter and using N++ doped polycrystalline silicon as a back surface field (BSF). A tunneling oxide layer is deposited between the polycrystalline silicon substrates to enhance carrier selectivity, reduce minority carrier recombination, and increase an open-circuit voltage of the solar cell. In addition, since a front surface of the TBC solar cell is free of metal electrodes, the light incident on the cell surface may be utilized as much as possible, increasing the current density of the solar cell and ultimately improving the photoelectric conversion efficiency.

Currently, the N-type TBC solar cell typically use silver paste and screen printing to prepare metal electrodes in the P-type region and the N-type region. Since metal electrodes in the P-type region and N-type region are both silver electrodes, the cost of the solar cell is significantly increased. Therefore, to address the high cost of silver electrodes in the N-type TBC solar cell, some companies or research institutions use electroplating to prepare the metal electrodes. Non-silver metal electrodes are achieved by electroplating nickel, copper, and tin metal electrodes sequentially on the rear surface, which reduces manufacture cost of the TBC solar cells. However, this method further results in a new problem. Besides the high cost and investment associated with electroplating equipment, wastewater treatment costs of electroplating significantly increase the manufacture cost of the solar cell. This is an environmentally unfriendly method for manufacturing metal electrodes, and mass production cannot be achieved in a short term.

Therefore, how to provide a TBC solar cell suitable for mass production and at a low cost remains an urgent problem to be solved for those skilled in the art.

### SUMMARY

The present disclosure aims to provide a P-type TBC solar cell and manufacturing method thereof to address the problems of high manufacture costs and difficulty in mass production of the TBC solar cell in the conventional art.

To address the aforementioned technical problems, the present disclosure provides a P-type TBC solar cell, comprising a P-type silicon substrate, wherein the rear surface of the P-type silicon substrate comprises a patterned N-type region;
in the N-type region, a first tunneling layer, an N-type polycrystalline silicon layer, a first conductive shielding layer, a first passivation anti-reflection layer, and a non-silver N fine finger are located sequentially from the rear surface of the P-type silicon substrate toward a direction away from the P-type silicon substrate;
where the non-silver N-type fine finger runs through the first passivation anti-reflection layer and contacts the first conductive shielding layer.

Optionally, in the P-type TBC solar cell, the rear surface of the P-type silicon substrate further comprises a patterned P-type region, and the P-type region does not overlap with the N-type region;
in the P-type region, a second tunneling layer, a P-type polycrystalline silicon layer, a second conductive shielding layer, a second passivation anti-reflection layer, and a non-silver P fine finger are located sequentially from the rear surface of the P-type silicon substrate toward the direction away from the P-type silicon substrate.

Optionally, in the P-type TBC solar cell, the first tunneling layer and the second tunneling layer are a continuous and integrated tunneling layer;
and/or,
the first passivation anti-reflection layer and the second passivation anti-reflection layer are a continuous and integrated passivation anti-reflection layer.

Optionally, in the P-type TBC solar cell, the P-type region and the N-type region are strip-shaped regions alternately arranged on the rear surface of the P-type silicon substrate.

Optionally, in the P-type TBC solar cell, the first conductive shielding layer and the second conductive shielding layer are made of a same material;
and/or,
the first passivation anti-reflection layer and the second passivation anti-reflection layer are made of a same material.

Optionally, in the P-type TBC solar cell, the first passivation anti-reflection layer comprises, from the inside to the outside, a first aluminum oxide passivation layer and a first silicon nitride anti-reflection layer.

Optionally, in the P-type TBC solar cell, a busbar of the P-type TBC solar cell is a silver busbar.

Optionally, in the P-type TBC solar cell, the P-type TBC solar cell is a busbar-less solar cell;
the N-type region and a P-type region of the P-type TBC solar cell are strip-shaped regions alternately arranged on the rear surface of the P-type silicon substrate;
a P fine finger and a P-region passivation anti-reflection layer are located in the P-type region;
the P fine finger runs through the P-region passivation anti-reflection layer and contacts the P-type silicon substrate;
the P fine finger is a continuous fine finger;
the N-type region is a segmented strip-shaped region composed of a plurality of N-type segments, and adjacent N-type segments are separated by a gap;
a bottom surface in the gap is consistent with a surface of the P-type region;
the gap is a placement region for a solde ribbon corresponding to the P fine finger; and
the N-type segment is a placement region for a solder ribbon corresponding to a non-silver N-type grid line.

A method for manufacturing a P-type TBC solar cell is provided, where a rear surface of a P-type silicon substrate comprises a patterned N-type region and a patterned P-type region, the method comprises:
providing a first tunneling layer on the N-type region;
providing an N-type polycrystalline silicon layer on a surface of the first tunneling layer;
providing a first conductive shielding layer on a surface of the N-type polycrystalline silicon layer;
providing a first passivation anti-reflection layer on a surface of the first conductive shielding layer to obtain a cell precursor;
metalizing the N-type region of the cell precursor to obtain a non-silver N fine finger running through the first passivation anti-reflection layer and contacting the first conductive shielding layer; and
metalizing the P-type region of the cell precursor to obtain a P fine finger.

Optionally, in the method for manufacturing the P-type TBC solar cell, the process of obtaining the cell precursor comprises:
providing a tunneling layer on the entire rear surface of the P-type silicon substrate;
providing the N-type polycrystalline silicon layer on the tunneling layer in the N-type region;
providing a P-type polycrystalline silicon layer on the tunneling layer in the P-type region, thereby obtaining a P-N junction silicon wafer;
providing a conductive shielding layer on an entire rear surface of the P-N junction silicon wafer; and
etching the conductive shielding layer by using ultraviolet laser to separate the conductive shielding layer into the first conductive shielding layer on the surface of the N-type polycrystalline silicon and a second conductive shielding layer on the surface of the P-type polycrystalline silicon, to obtain the cell precursor.

The P-type TBC solar cell provided by the present disclosure comprises a P-type silicon substrate, wherein a rear surface of the P-type silicon substrate comprises a patterned N-type region; in the N-type region, a first tunneling layer, an N-type polycrystalline silicon layer, a first conductive shielding layer, a first passivation anti-reflection layer, and a non-silver N fine finger are located sequentially from the rear surface of the P-type silicon substrate toward a direction away from the P-type silicon substrate; wherein the non-silver N-type fine finger runs through the first passivation anti-reflection layer and contacts the first conductive shielding layer. The present disclosure uses a non-silver N fine finger as a metal electrode in the N-type region on the rear surface of the cell, significantly reducing the production cost of the P-type TBC solar cell. Furthermore, the conductive shielding layer is arranged between the non-silver N fine finger and the corresponding polycrystalline silicon to prevent the metal slurry from directly contacting the polycrystalline silicon in the sintering process of the non-silver N fine finger, thereby damaging the polycrystalline silicon. Instead, the non-silver N fine finger achieves good ohmic contact with the conductive shielding layer, significantly reducing contact resistance and increasing the fill factor of the cell. Moreover, the conductive shielding layer further effectively reduces the reverse saturation current density of the cell, increases the open-circuit voltage of the cell, and improves the photoelectric conversion efficiency of the cell. The present disclosure further provides a method for manufacturing the P-type TBC solar cell with the above beneficial effects.

### BRIEF DESCRIPTION OF THE DRAWINGS

In order to illustrate technical solutions of embodiments of the present disclosure or the conventional art more clearly, drawings used in the embodiments or conventional technology descriptions are briefly described below. Apparently, the drawings described below represent only some embodiments of the present disclosure. For those skilled in the art, other drawings may be obtained based on these drawings without creative work.
FIG. 1 is a schematic structural diagram according to a specific embodiment of a P-type TBC solar cell of the present disclosure.
FIG. 2 is a schematic diagram illustrating a positional relationship between a fine finger and a solder ribbon according to a specific embodiment of a P-type TBC solar cell of the present disclosure.
FIG. 3 is a schematic structural diagram according to another specific embodiment of a P-type TBC solar cell of the present disclosure.
FIG. 4 is a schematic structural diagram according to yet another specific embodiment of a P-type TBC solar cell of the present disclosure.
FIG. 5 is a schematic three-dimensional structure diagram according to a specific embodiment of a P-type TBC solar cell of the present disclosure.
FIG. 6 is a schematic structural diagram according to a specific embodiment of a P-type TBC solar cell of the present disclosure.

**Reference numerals:**

| | | | |
|---|---|---|---|
| 10: | P-type silicon substrate; | 21: | first tunneling layer; |
| 22: | second tunneling layer; | 31: | N-type polycrystalline silicon layer; |
| 32: | P-type polycrystalline silicon layer; | 41: | first conductive shielding layer; |
| 42: | second conductive shielding layer; | 51A: | first aluminum oxide passivation layer; |
| 51B: | first silicon nitride anti-reflection layer; | 52A: | P region passivation layer; |
| 52B: | P region anti-reflection layer; | 52A': | second aluminum oxide passivation layer; |
| 52B': | second silicon nitride anti-reflection layer; | 61: | non-silver N fine finger; |
| 62: | P fine finger; | 62': | non-silver P fine finger; |
| 20: | tunneling layer; | 50: | passivation anti-reflection layer; |
| 71: | front surface anti-reflection layer; | 72: | front surface passivation layer. |

### DETAILED DESCRIPTION

In order to enable those skilled in the art to better understand the solutions of the present disclosure, the present disclosure is further described in detail below in conjunction with accompanying drawings and specific embodiments. Apparently, the embodiments described are only part, not all of the embodiments of the present disclosure. Based on the embodiments in the present disclosure, all other embodiments obtained by those skilled in the art without creative work are within the scope of protection of the present disclosure.

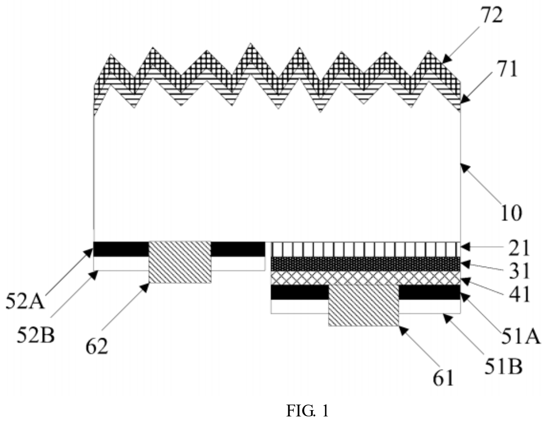

The core of the present disclosure is to provide a P-type TBC solar cell. Reference is made to FIG. 1, which is a schematic structural diagram of a specific embodiment, and is referred to as a first specific embodiment. The solar cell comprises a P-type silicon substrate 10, where a rear surface of the P-type silicon substrate 10 comprises a patterned N-type region;
in the N-type region, a first tunneling layer 21, an N-type polycrystalline silicon layer 31, a first conductive shielding layer 41, a first passivation anti-reflection layer, and a non-silver N fine finger 61 are located sequentially from the rear surface of the P-type silicon substrate 10 toward a direction away from the P-type silicon substrate 10;
wherein the non-silver N-type fine finger 61 runs through the first passivation anti-reflection layer and contacts the first conductive shielding layer 41.

Reference is made to FIG. 1, which shows a polycrystalline silicon arranged only within the N-type region. That is, the P-type TBC solar cell only contains an N-type polycrystalline silicon layer 31. Accordingly, a fine gate connected to the P-type region is referred to as a P fine finger 62. In a specific embodiment shown in FIG. 1, the P fine finger 62 directly contacts the P-type silicon substrate 10.

Based on the solar cell shown in FIG. 1, the P-type TBC solar cell may be further defined as a busbar-less solar cell.
the N-type region and the P-type region of the P-type TBC solar cell are strip-shaped regions alternately arranged on the rear surface of the P-type silicon substrate 10.
the P fine finger 62 and a P-region passivation anti-reflection layer are located in the P-type region;
the P fine finger 62 runs through the P-region passivation anti-reflection layer and contacts the P-type silicon substrate 10;
the P fine finger 62 is a continuous fine finger;
the N-type region is a segmented strip-shaped region composed of a plurality of N-type segments, and adjacent N-type segments are separated by a gap;
a bottom surface in the gap is consistent with a surface of the P-type region;
the gap is a placement region for a solder ribbon corresponding to the P fine finger 62; and
the N-type segment is a placement region for a solder ribbon corresponding to a non-silver N-type grid line.

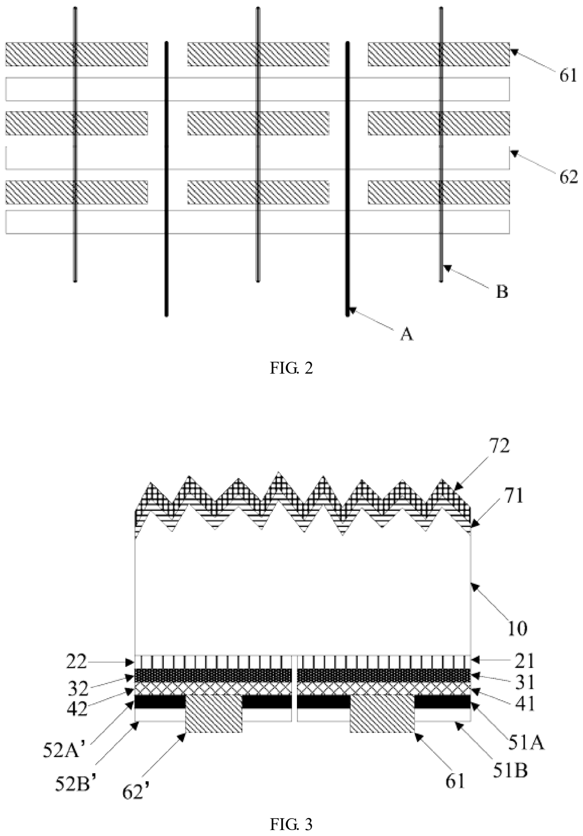

The structure of the busbar-less P-type TBC solar cell is described above. The distribution of fine fingers on the rear surface is shown in FIG. 2. As can be seen from FIG. 1, the rear surface of the cell shown in FIG. 2 is not a flat surface. Instead, the N-type region where the non-silver N-type grid line is located is higher, while the P-type region where the P fine finger 62 is located is lower. In the absence of the busbar, the solder ribbon of photovoltaic module will be blocked by the higher N-type region and may not be in close contact with the lower P fine finger 62. In a preferred embodiment, both the N-type region and the P-type region are first configured as strip-shaped regions. The higher N-type region is then segmented by a gap. When the solder ribbon (indicated by A in FIG. 2) is arranged to connect different P fine finger 62 in series, the solder ribbon is passed through the gap. This avoids the obstruction of the higher N-type region on the solder ribbon and ensures close contact between the solder ribbon and the P fine finger 62. The solder ribbon (indicated by B in FIG. 2) connected to different non-silver N-type grid lines in series is arranged to pass through the N-type segments located at the same position in different N-type regions.

The P-region passivation anti-reflection layer may be referred to as the first passivation anti-reflection layer. From the inside to the outside, the P-region passivation anti-reflection layer is divided into a P-region passivation layer 52A and a P-region anti-reflection layer 52B. The materials and thicknesses may also refer to the first passivation anti-reflection layer and will not be further described here.

As another specific embodiment, the P-type TBC solar cell may also be a solar cell with a busbar, wherein the busbar of the P-type TBC solar cell is a silver busbar. In this specific embodiment, the busbar, which only accounts for a small proportion of back electrodes of the cell, is configured as a silver busbar to achieve the purpose of enhancing the current collection efficiency of the busbar and facilitating component soldering. Certainly, the P-type TBC solar cell may also be a busbar-less cell, which may be selected according to actual requirements.

Silver paste corresponding to the silver busbar has a solid content ranging from 50% to 90%, including any one of endpoints such as 50.0%, 64.2%, or 90.0%. Furthermore, the first conductive shielding layer 41 has a thickness ranging from 30 nanometers to 150 nanometers, including any one of endpoints such as 30.0 nanometers, 48.5 nanometers, or 150.0 nanometers. Furthermore, the number of silver busbars ranges from 5 to 20, including any one of endpoints such as 5.0, 12.0, or 20.0.

In addition, the busbar of the P-type TBC solar cell in the cell of the present disclosure may be an aluminum busbar, a silver busbar, or a busbar made of other materials, which is not limited here.

Preferably, the first passivation anti-reflection layer comprises, from the inside to the outside, a first aluminum oxide passivation layer 51A and a first silicon nitride anti-reflection layer 51B. Reference is made to FIG. 1, in the embodiment, the passivation and anti-reflection are implemented by separate layers, achieving better passivation and anti-reflection effects. Furthermore, aluminum oxide is used as the passivation layer, and silicon nitride is used as the anti-reflection layer, which are low-cost options for improving manufacture efficiency. Certainly, other materials may also be selected for the passivation layer and the anti-reflection layer according to the actual situation, which is not limited here.

In the present disclosure, the conductive shielding layer generally refers to conductive oxides, nitrides, and fluorides such as In₂O₃, SnO₂, ZnO, CdO, TiN, In₂O₃:Sn(ITO), ZnO:In(IZO), ZnO:Al(AZO), SnO₂:F(FTO), TiO₂:Ta; or mixed oxides such as In₂O₃-ZnO, CdIn₂O₄, Cd₂SnO₄, and Zn₂SnO₄. AZO is a commonly used material, and AZO is used as an example below. The work functions of AZO and non-silver N fine finger 61 are more closely matched, thereby resulting in lower transmission losses within the cell and significantly improving the photovoltaic conversion efficiency of the cell.

The non-silver N fine finger 61 may be one of aluminum (Al) fine finger, copper (Cu) fine finger, nickel (Ni) fine finger, or titanium-tungsten (TiW) fine finger, or a grid of an alloy of multiple materials.

In the present disclosure, before preparing the metal electrode (i.e., the non-silver N fine finger 61), a layer of AZO (zinc oxide doped with Al₂O₃) is deposited on the N-type polycrystalline silicon layer 31 of the rear surface. The combined cost of the first conductive shielding layer 41 and the non-silver N fine finger 61 is still significantly lower than the cost of directly using metal silver to prepare the metal electrode.

It should be noted that aluminum is highly reactive and easily burns through polycrystalline silicon at a high temperature. Consequently, aluminum cannot currently be used directly as a grid line on the surface of the N-type polycrystalline silicon layer 31. Therefore, the first conductive shielding layer 41 is required to provide insulation and prevent direct contact between the aluminum slurry used to prepare the non-silver N fine finger 61 and the polycrystalline silicon. During the metallization process, the aluminum slurry sintered at a high temperature allows a good ohmic contact between the non-silver N fine finger 61 and the first conductive shielding layer 41, with a contact resistivity of less than 1.5 mΩ·cm².

The P-type TBC solar cell provided by the present disclosure comprises a P-type silicon substrate 10, where the rear surface of the P-type silicon substrate 10 comprises a patterned N-type region; in the N-type region, a first tunneling layer 21, an N-type polycrystalline silicon layer 31, a first conductive shielding layer 41, a first passivation anti-reflection layer, and a non-silver N fine finger 61 are located sequentially from the rear surface of the P-type silicon substrate 10 toward a direction away from the P-type silicon substrate; the non-silver N fine finger 61 runs through the first passivation anti-reflection layer and contacts the first conductive shielding layer 41. In the present disclosure, the non-silver N fine finger 61 is used as the metal electrode in the N-type region on the rear surface of the cell, which significantly reduces the production cost of the P-type TBC solar cell. Furthermore, the conductive shielding layer is provided between the non-silver N fine finger 61 and the corresponding polycrystalline silicon, which prevents metal slurry from directly contacting with the polycrystalline silicon during sintering the non-silver N fine finger 61, which may damage the polycrystalline silicon. Instead, the non-silver N fine finger 61 establishes good ohmic contact with the conductive shielding layer, which significantly reduces contact resistance and greatly increases the cell's fill factor. Furthermore, the conductive shielding layer may also effectively reduce the cell's reverse saturation current density, increase the cell's open-circuit voltage and improve the cell's photoelectric conversion efficiency.

Based on the first embodiment, the structure on the rear surface of the P-type TBC solar cell is further improved to obtain a second embodiment, the corresponding structural diagram of the second embodiment is shown in FIG. 3. The structure of the second embodiment comprises a P-type silicon substrate 10, wherein the rear surface of the P-type silicon substrate comprises a patterned N-type region;
in the N-type region, a first tunneling layer 21, an N-type polycrystalline silicon layer 31, a first conductive shielding layer 41, a first passivation anti-reflection layer, and a non-silver N fine finger 61 are located sequentially from the rear surface of the P-type silicon substrate 10 toward a direction away from the P-type silicon substrate;
the non-silver N fine finger 61 runs through the first passivation anti-reflection layer and contacts the first conductive shielding layer 41;
the rear surface of the P-type silicon substrate 10 further comprises a patterned P-type region; the P-type region does not overlap with the N-type region;
in the P-type region, a second tunneling layer 22, a P-type polycrystalline silicon layer 32, a second conductive shielding layer 42, a second passivation anti-reflection layer, and a non-silver P fine finger 62' are located sequentially from the rear surface of the P-type silicon substrate 10 toward the direction away from the P-type silicon substrate.

In a specific embodiment, the P-type TBC solar cell is supplemented with a P-type polycrystalline silicon layer 32 as a P+ region to further improve the solar cell's photoelectric conversion efficiency. In addition, the fine finger structure corresponding to the P-type polycrystalline silicon layer 32 is also replaced with a combination of a conductive shielding layer and a non-silver fine finger, namely, the second conductive shielding layer 42 and non-silver P fine finger 62'.

In one specific embodiment, the first tunneling layer 21 and the second tunneling layer 22 are a continuous and integrated tunneling layer;
and/or,
the first passivation anti-reflection layer and the second passivation anti-reflection layer are a continuous and integrated passivation anti-reflection layer.

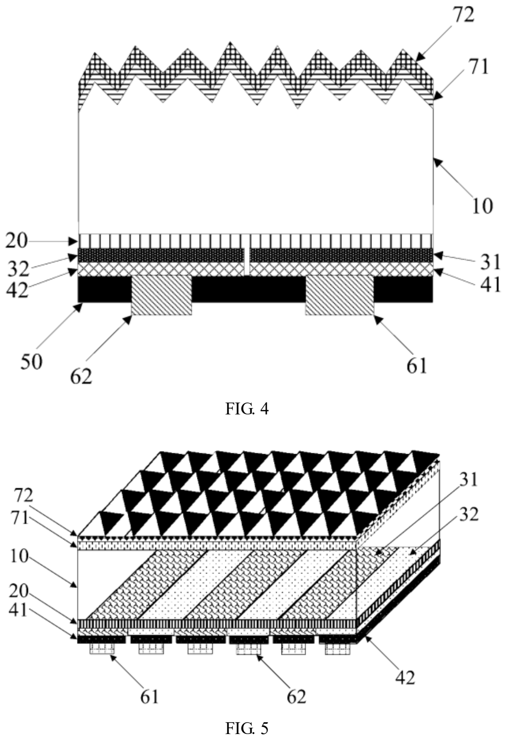

Reference is made to FIG. 4, in other words, in one specific embodiment, the tunneling layers located in the P-type region and the N-type region may be a single and integrated layer (indicated by 20 in FIG. 4), which may be manufactured simultaneous during production. Similarly, the first passivation anti-reflection layer and the second passivation anti-reflection layer may also be a single and integrated layer (indicated by 50 in FIG. 4). During production, the passivation anti-reflection layers for both regions can be fabricated simultaneously, which eliminates the need to distinguish between the two structures located in different regions. This simplifies the production process and improves efficiency.

In one specific embodiment, the first conductive shielding layer 41 and the second conductive shielding layer 42 are made of the same material;
and/or,
the first passivation anti-reflection layer and the second passivation anti-reflection layer are made of the same material.

In one specific embodiment, in the P-type TBC solar cell, all conductive shielding layers are made of the same material, and all passivation anti-reflection layers are made of the same material, which further simplifies the production process and improves efficiency.

The structure of the second passivation anti-reflection layer may refer to the first passivation anti-reflection layer, and comprises, from the inside to the outside, a second aluminum oxide passivation layer 52A' and a second silicon nitride anti-reflection layer 52B'.

Since the first conductive shielding layer 41 is provided between the non-silver N fine finger 61 and the N-type polycrystalline silicon layer 31, and the second conductive shielding layer 42 is provided between the non-silver P fine finger 62' and the P-type polycrystalline silicon layer 32, the reverse saturation current density (J0, metal) caused by the metal on the surface of the P-type polycrystalline silicon layer 32 and the surface of the N-type polycrystalline silicon layer 31 is 0, and the reverse saturation current density (J01) in a quasi-neutral region and the reverse saturation current density (J02) in a space charge region of the cell may be effectively reduced, thereby improving the open-circuit voltage of the cell. Finally, the P-type polycrystalline silicon region has a contact resistivity of 0.5mΩ•cm² to 1.5mΩ•cm², the N-type polycrystalline silicon layer 31 has a contact resistivity of 0.5mΩ•cm² to 1.5mΩ•cm², J01 is 10fA/cm² to 20fA/cm²; and J02 is 0.5 nA/cm² to 3nA/cm². In addition, thermal stability temperatures of the two conductive shielding layers are above 500°C , generally reaching 900°C , and the resistivity decreases with the increase of doping ratio of Al₂O₃ in AZO.

Certainly, according to common knowledge in the relevant art, the N-type polycrystalline silicon layer 31 and the P-type polycrystalline silicon layer 32 should be insulated from each other. In one specific embodiment, the N-type polycrystalline silicon layer 31 and the P-type polycrystalline silicon layer 32 may not be in contact with each other, and the first conductive shielding layer 41 and the second conductive shielding layer 42 should also be insulated from each other, e.g., the two conductive shielding layers are not in contact with each other.

Certainly, FIG. 5 only indicates a specific embodiment of the P-type TBC solar cell. In FIG. 5, the N-type region and the P-type region are arranged alternately. In actual production, the N-type region and the P-type region on the rear surface of the P-type TBC solar cell may also be divided in other ways.

In one specific embodiment, the P-type region and the N-type region are strip-shaped regions arranged alternately on the rear surface of the P-type silicon substrate 10. This structure significantly reduces the difficulty of manufacturing the corresponding conductive shielding layer and facilitates the subsequent deposition of the corresponding non-silver fine finger on the corresponding conductive shielding layer to form interdigitated electrodes, thereby improving the cell production efficiency and qualified product yield. A specific embodiment of the interdigitated electrodes on the rear surface of the P-type TBC solar cell may be seen in FIG. 5, which is a schematic diagram of a three-dimensional structure of the P-type TBC solar cell provided by the present disclosure.

In another aspect, the conductive shielding layer (including at least one of the first conductive shielding layer 41 and the second conductive shielding layer 42) in the present disclosure comprises aluminum oxide in a range of 2% to 25%, including endpoints such as any one of 2.0%, 16.2%, or 25.0%, with the balance being zinc oxide.

In another aspect, a quantity of fine fingers corresponding to the N-type region and/or the P-type region ranges from 120 to 200, including endpoints such as any one of 120.0, 164.0, or 200.0. The width of the non-silver N fine finger 61 and/or the non-silver P fine finger 62' ranges from 100 µm to 200 µm, including endpoints such as any one of 100.0 µm, 154.2µm, or 200.0 µm. The height of the non-silver N fine finger 61 and/or the non-silver P fine finger 62' ranges from 10 µm to 40 µm, including endpoints such as any one of 10.0 µm, 14.2 µm, or 40.0 µm.

Of course, in addition to the structure of the rear surface of the P-type TBC solar cell described above, the P-type TBC solar cell further comprises other structures. Reference is made to the P-type TBC solar cell in FIG. 1, in the specific embodiment represented by FIG. 1, the light-facing side of the solar cell is a textured surface, and from the inside to the outside, a front surface passivation layer 72 and a front surface anti-reflection layer 71 are provided.

The tunneling layer (including at least one of the first tunneling layer 21 and the second tunneling layer 22) of the present disclosure has a thickness ranging from 1 nm to 8 nm, including endpoints such as any one of 1.0 nm, 4.1 nm, or 8.0 nm. The thickness of the N-type polycrystalline silicon layer 31 and/or the P-type polycrystalline silicon layer 32 ranges from 80 nm to 200 nm, including endpoints such as any one of 80.0 nm, 162.0 nm, or 200.0 nm. The N-type polycrystalline silicon layer 31 has a doping concentration ranging from 1E20 atoms/cm³ to 6E20 atoms/cm³, including endpoints. The P-type polycrystalline silicon layer 32 has a doping concentration ranging from 1E18 atoms/cm³ to 1E20 atoms/cm³, including endpoints. Preferably, the thickness of the N-type polycrystalline silicon layer 31 may be the same as that of the P-type polycrystalline silicon layer 32 to reduce production complexity.

The above parameter ranges are preferred values obtained after extensive theoretical calculations and practical tests. Certainly, other values may be selected based on actual conditions, which is not limited in the present application.

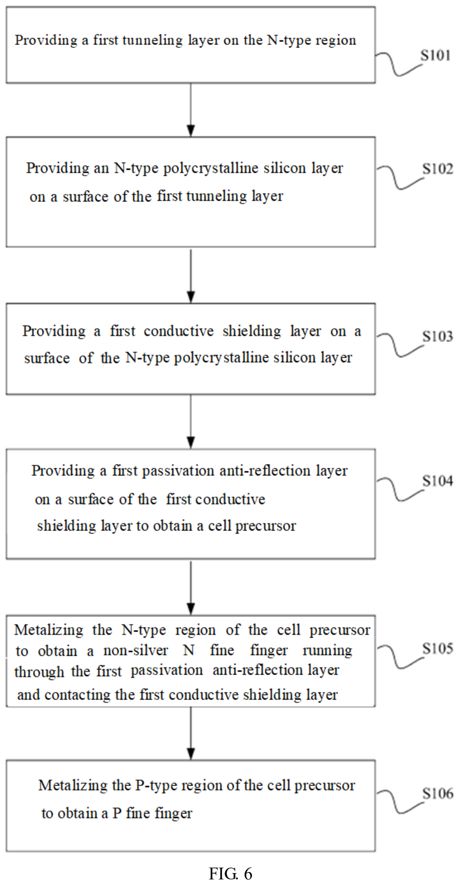

The present disclosure further provides a method for manufacturing a P-type TBC solar cell. FIG. 6 shows a flow diagram of a specific embodiment, which is referred to as a third specific embodiment. The rear surface of the P-type silicon substrate comprises a patterned N-type region and a patterned P-type region. The method comprises:
S101: providing a first tunneling layer in the N-type region.
S102: providing an N-type polycrystalline silicon layer on a surface of the first tunneling layer.
S103: providing a first conductive shielding layer on a surface of the N-type polycrystalline silicon layer.
S104: providing a first passivation anti-reflection layer on a surface of the first conductive shielding layer to obtain a cell precursor.
S105: metalizing the N-type region of the cell precursor to obtain a non-silver N fine finger running through the first passivation anti-reflection layer and contacting the first conductive shielding layer.
S106: metalizing the P-type region of the cell precursor to obtain a P fine finger.

This embodiment corresponds to the P-type TBC solar cell described above. Therefore, the parameters of the various structures in this embodiment refer to the description of the P-type TBC solar cell described above and will not be further elaborated here.

Steps S105 and S106 do not have a fixed sequence and may be altered based on actual circumstances.

Certainly, in addition to the above steps, a front surface passivation layer and a front surface anti-reflection layer may also be sequentially arranged in the front surface of the P-type silicon substrate.

In a preferred embodiment, the process of obtaining the cell precursor comprises:
A1: providing a tunneling layer on the entire rear surface of the P-type silicon substrate.
A2: providing the N-type polycrystalline silicon layer on the tunneling layer in the N-type region; and providing a P-type polycrystalline silicon layer on the tunneling layer in the P-type region, thereby obtaining a P-N junction silicon wafer.

Certainly, to ensure proper operation of the P-type TBC solar cell, the N-type polycrystalline silicon layer and the P-type polycrystalline silicon layer in the P-N junction silicon wafer should also be isolated from each other. In a preferred embodiment, the N-type polycrystalline silicon layer and the P-type polycrystalline silicon layer comprises:
B1: providing a polycrystalline silicon layer on the surface of the tunneling layer.
B2: performing phosphorus-doping and boron-doping on the polycrystalline silicon layer according to the region division of the N-type region and the P-type region, thereby obtaining the N-type polycrystalline silicon layer and the P-type polycrystalline silicon layer.
B3: separating the N-type polycrystalline silicon layer and the P-type polycrystalline silicon layer by using an ultraviolet laser.

After separation, the minority carrier lifetime degradation within the cell is less than approximately 10 µs, and the relative minority carrier lifetime degradation is less than 0.9%, which further extends the minority carrier lifetime and improves the photoelectric conversion efficiency of the cell. Furthermore, the ultraviolet laser is a picosecond laser, which enhances the separation effect.

In this specific embodiment, the tunneling layer and the polycrystalline silicon layer may be deposited by PECVD or LPCVD (low-pressure chemical vapor deposition).

A3: arranging a conductive shielding layer on the entire rear surface of the P-N junction silicon wafer.

The process of arranging the conductive shielding layer in this step comprises:
arranging the conductive shielding layer on the entire rear surface of the P-N junction silicon wafer by magnetron sputtering or reactive plasma deposition.

Both methods are mature, low-cost, and suitable for large-scale production.

A4: etching the conductive shielding layer by using ultraviolet laser to separate the conductive shielding layer into the first conductive shielding layer on the surface of the N-type polycrystalline silicon and a second conductive shielding layer on a surface of the P-type polycrystalline silicon, to obtain the cell precursor.

In the step, the portion of the conductive shielding layer corresponding to the N-type region and the portion corresponding to the P-type region are separated to obtain the first conductive shielding layer and the second conductive shielding layer.

In this specific embodiment, the process of providing the first conductive shielding layer and the second conductive shielding layer is further disassembled. First, the conductive shielding layer is provided entirely, and then the AZO on the N-type region and the P-type regions is separated by laser etching to obtain the first conductive shielding layer and the second conductive shielding layer. This simplifies the process and balances high production efficiency with low production costs.

Furthermore, the ultraviolet laser has an energy ranging from 0.01W to 5W, a laser frequency of 100kHz to 500kHz, a spot diameter of 10µm to 30µm, a minority carrier lifetime degradation of 0µs to 10µs, and a relative degradation of 0% to 0.9%, which further improves the minority carrier lifetime and the photovoltaic conversion efficiency of the cell.

The present disclosure provides a method for manufacturing a P-type TBC solar cell, wherein the rear surface of a P-type silicon substrate comprises a patterned N-type region and a patterned P-type region, and the method comprises: providing a first tunneling layer on the N-type region; providing an N-type polycrystalline silicon layer on a surface of the first tunneling layer; providing a first conductive shielding layer on a surface of the N-type polycrystalline silicon layer; providing a first passivation anti-reflection layer on a surface of the first conductive shielding layer to obtain a cell precursor; metalizing the N-type region of the cell precursor to obtain a non-silver N fine finger running through the first passivation anti-reflection layer and contacting the first conductive shielding layer; and metalizing the P-type region of the cell precursor to obtain a P fine finger. In the present disclosure, the non-silver N fine finger is used as a metal electrode in the N-type region on the rear surface of the cell, which significantly reduces the production cost of the P-type TBC solar cell. Furthermore, the conductive shielding layer is placed between the non-silver N fine finger and the corresponding polycrystalline silicon, which prevents metal slurry from directly contacting with the polycrystalline silicon during sintering the non-silver N fine finger, which may damage the polycrystalline silicon. Instead, the non-silver N fine finger establishes good ohmic contact with the conductive shielding layer, which significantly reduces contact resistance and increases the cell's fill factor. Furthermore, the conductive shielding layer can also effectively reduce the cell's reverse saturation current density, increase the cell's open-circuit voltage and improve the cell's photoelectric conversion efficiency.

Various embodiments are described in this specification in a progressive manner. Each embodiment focuses on the differences from the other embodiments. Reference is made to the corresponding or similar portions of the various embodiments. The device disclosed in the embodiments is described briefly because it corresponds to the method disclosed in the embodiments. Relevant details can refer to the method description.

It should be noted that, in this specification, relational terms such as a first and a second, and the like, are used solely to distinguish one entity or operation from another entity or operation, and do not necessarily require or imply any actual relationship or order between these entities or operations. Furthermore, the terms "comprise", "include" or any other variations thereof are intended to encompass non-exclusive inclusion, such that a process, method, article, or apparatus comprising a list of elements includes not only those elements but also other elements not expressly listed, or elements inherent to such process, method, article, or apparatus. Without further limitation, the phrase "comprising a..." does not preclude the presence of additional identical elements in the process, method, article, or apparatus comprising the recited elements.

The P-type TBC solar cell and its manufacturing method provided by the present disclosure are described above in detail. Specific examples are used herein to illustrate the principles and implementation methods of the present disclosure. The description of the above examples is intended only to facilitate understanding of the methods and core concepts of the present disclosure. It should be noted that, various improvements and modifications to the present disclosure may be made by those skilled in the art, without departing from the principles of the present disclosure, and such improvements and modifications fall within the protection scope of the claims of the present disclosure.

## Claims

1. A P-type tunneling oxide passivated back contact (TBC) solar cell, which comprises:
a P-type silicon substrate, wherein a rear surface of the P-type silicon substrate comprises a patterned N-type region;
in the N-type region, a first tunneling layer, an N-type polycrystalline silicon layer, a first conductive shielding layer, a first passivation anti-reflection layer, and a non-silver N fine finger located sequentially from the rear surface of the P-type silicon substrate toward a direction away from the P-type silicon substrate;
wherein the non-silver N-type fine finger runs through the first passivation anti-reflection layer and contacts the first conductive shielding layer.

2. The P-type TBC solar cell according to claim 1, wherein the rear surface of the P-type silicon substrate further comprises a patterned P-type region, and the P-type region does not overlap with the N-type region;
in the P-type region, a second tunneling layer, a P-type polycrystalline silicon layer, a second conductive shielding layer, a second passivation anti-reflection layer, and a non-silver P fine finger are located sequentially from the rear surface of the P-type silicon substrate toward the direction away from the P-type silicon substrate.

3. The P-type TBC solar cell according to claim 2, wherein the first tunneling layer and the second tunneling layer are a continuous and integrated tunneling layer;
and/or,
the first passivation anti-reflection layer and the second passivation anti-reflection layer are a continuous and integrated passivation anti-reflection layer.

4. The P-type TBC solar cell according to claim 2, wherein the P-type region and the N-type region are strip-shaped regions alternately arranged on the rear surface of the P-type silicon substrate.

5. The P-type TBC solar cell according to claim 2, wherein the first conductive shielding layer and the second conductive shielding layer are made of a same material;
and/or
the first passivation anti-reflection layer and the second passivation anti-reflection layer are made of a same material.

6. The P-type TBC solar cell according to claim 1, wherein the first passivation anti-reflection layer comprises, from the inside to the outside, a first aluminum oxide passivation layer and a first silicon nitride anti-reflection layer.

7. The P-type TBC solar cell according to claim 1, wherein a busbar of the P-type TBC solar cell is a silver busbar.

8. The P-type TBC solar cell according to claim 1, wherein the P-type TBC solar cell is a busbar-less solar cell;
the N-type region and a P-type region of the P-type TBC solar cell are strip-shaped regions alternately arranged on the rear surface of the P-type silicon substrate;
a P fine finger and a P-region passivation anti-reflection layer are located in the P-type region;
the P fine finger runs through the P-region passivation anti-reflection layer and contacts the P-type silicon substrate;
the P fine finger is a continuous fine finger;
the N-type region is a segmented strip-shaped region composed of a plurality of N-type segments, and adjacent N-type segments are separated by a gap;
a bottom surface in the gap is consistent with a surface of the P-type region;
the gap is a placement region for a solder ribbon corresponding to the P fine finger; and
the N-type segment is a placement region for a solder ribbon corresponding to a non-silver N-type grid line.

9. A method for manufacturing a P-type TBC solar cell, wherein a rear surface of a P-type silicon substrate comprises a patterned N-type region and a patterned P-type region, and the method comprises:
providing a first tunneling layer on the N-type region;
providing an N-type polycrystalline silicon layer on a surface of the first tunneling layer;
providing a first conductive shielding layer on a surface of the N-type polycrystalline silicon layer;
providing a first passivation anti-reflection layer on a surface of the first conductive shielding layer to obtain a cell precursor;
metalizing the N-type region of the cell precursor to obtain a non-silver N fine finger running through the first passivation anti-reflection layer and contacting the first conductive shielding layer; and
metalizing the P-type region of the cell precursor to obtain a P fine finger.

10. The method for manufacturing a P-type TBC solar cell according to claim 9, wherein a process for obtaining the cell precursor comprises:
providing a tunneling layer on the entire rear surface of the P-type silicon substrate;
providing the N-type polycrystalline silicon layer on the tunneling layer in the N-type region;
providing a P-type polycrystalline silicon layer on the tunneling layer in the P-type region, thereby obtaining a P-N junction silicon wafer;
providing a conductive shielding layer on an entire rear surface of the P-N junction silicon wafer; and
etching the conductive shielding layer by using ultraviolet laser to separate the conductive shielding layer into the first conductive shielding layer on the surface of the N-type polycrystalline silicon and a second conductive shielding layer on a surface of the P-type polycrystalline silicon, to obtain the cell precursor.
